# EUROPEAN PATENT APPLICATION

(11) **EP 1 289 006 A1**
(43) Date of publication of application: **05.03.2003**
(21) Application number: 01925963.9
(22) Date of filing: 26.04.2001
(51) Int. Cl.: H01L 21/68, H01L 21/205

(54) **WAFER SUPPORTING DEVICE OF SEMICONDUCTOR MANUFACTURING DEVICE**

(30) Priority: 28.04.2000 JP 2000131195
(71) Applicant: Applied Materials, Inc., Santa Clara, California 95054 (US)
(72) Inventor: TAKAGI, Yoji, c/o Applied Materials Japan, Inc., Narita-shi, Chiba 286-8516 (JP)
(74) Representative: Draper, Martyn John
(86) International application number: JP0103632
(87) International publication number: WO01084622

(57) **Abstract**

The wafer supporting device of the present invention comprises a wafer support, disposed within a process chamber in a semiconductor manufacturing apparatus having respective heat sources in upper and lower portions thereof; a lift member extending from the outside of the support area of the wafer support to the inside and having an inclined upper surface; an arc-shaped lift ring for supporting the lift member; and a lift pin, adapted to vertically move through a through hole in the wafer support, having an upper end part connected to the lift ring; wherein the through hole is covered and substantially closed with the lift ring when the lift pin descends. This eliminates the unevenness in temperature distribution caused by the through hole.

## Description

### Technical Field

The present invention relates to a wafer supporting device in a semiconductor manufacturing apparatus and, more particularly, is concerned with means, provided in the wafer supporting device, for vertically moving a wafer.

### Background Art

Known as semiconductor manufacturing apparatus are those of a single wafer processing type in which silicon wafers are processed one by one. Usually, in the single wafer type semiconductor apparatus, a wafer supporting device for horizontally supporting only a single wafer is disposed within a process chamber.

A typical wafer supporting device is basically constituted by a wafer support, i.e., so-called susceptor, on which a wafer rests. Also, the wafer supporting device is provided with a lift mechanism for vertically moving with respect to the susceptor. In general, a conventional lift mechanism has a plurality of lift pins extending through the susceptor. When the lift pins are moved up or down, a wafer, which is supported on the upper ends of the lift pins, can be moved up or down. Such a lift mechanism makes it possible for the wafer on a blade of a transfer robot to be transferred onto the susceptor or, on the contrary, the wafer to be transferred from the susceptor to the transfer robot.

In the conventional wafer supporting device mentioned above, the lift pins are positioned lower than the upper surface of the susceptor when supporting the wafer. Therefore, if the lift pins are raised in order to lift the wafer from the susceptor, the upper ends of lift pins may abut against the underside of the wafer, thereby damaging the contact points. Damages on the underside of the wafer may cause adverse effects in later processes.

Also, since the underside of the wafer is supported by the upper ends of lift pins alone when the wafer is moved up and down, the wafer is likely to shift its position, whereby there is a possibility of the wafer placing out of the support area of the susceptor when landed on the susceptor.

Meanwhile, in an epitaxial growth apparatus, which is one of semiconductor manufacturing apparatus, heat sources are arranged above and below the susceptor such that the wafer on the susceptor can be heated to a predetermined temperature. In this case, though it is desirable that the surface of the susceptor as a whole have a uniform temperature distribution, the temperature distribution in the surface of the susceptor tends to become uneven since the susceptor is formed with through holes for passing the lift pins therethrough.

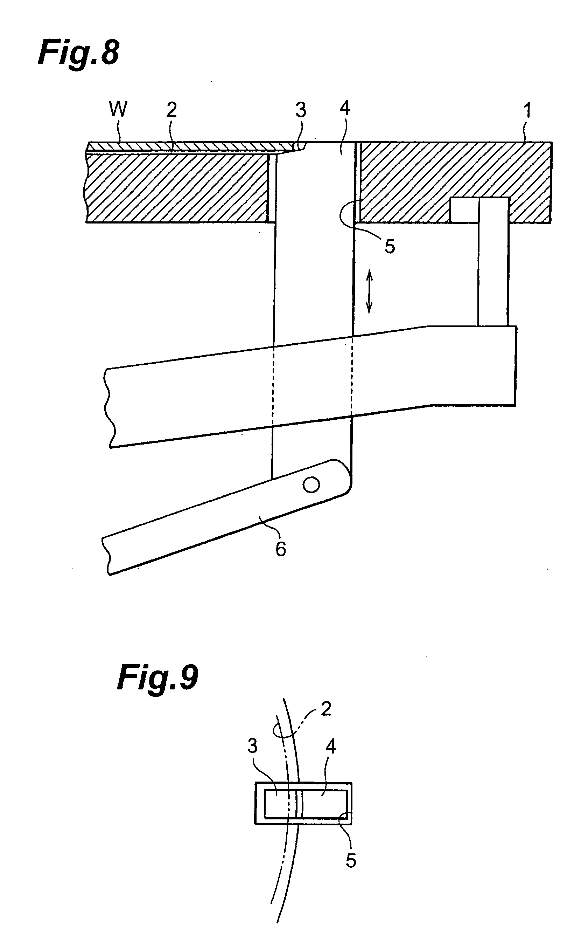

In order to overcome various shortcomings mentioned above, the inventors carried out various studies and, as a result, have conceived a wafer supporting device comprising a wafer support having an upper surface provided with a support area for supporting a wafer; and a plurality of lift members having an upper surface with an inclined surface inclining downward toward the inside, the inclined surface extending from the outside of the support area of the wafer support to the inside of the support area, the lift member being able to be vertically moved between respective positions below and above the wafer support. This configuration is specifically shown in Figs. 8 and 9.

In Figs. 8 and 9, numeral 1 refers to a susceptor which is the wafer support for supporting a wafer W, whereas numeral 2 refers to a wafer support area. Numeral 3 refers to a lift member. The lift member 3 is formed as a constituent part of a lift pin 4.

Due to the position of the lift member 3 and its inclined upper surface, it only abuts against the lower edge of the outer periphery of the wafer W without coming into contact with the underside of the wafer W. Therefore, the underside of the wafer W can be prevented from being damaged. Also, since the upper surface of the lift member 3 is raised toward the outside, horizontal positional deviations can be suppressed.

While it is preferred in a heat treatment apparatus such as an epitaxial growth apparatus that the lift member 3 or lift pin 4 be integrated with the susceptor 1 so as to be rotatable therewith, the susceptor 1 expands or shrinks upon temperature changes in the above-mentioned configuration, whereby the lift pin 4 cannot be integrated with the susceptor 1 by such means as suspension. Namely, when the lift pin 4 and, consequently, the lift member 3 greatly shift their positions due to the thermal expansion/shrinkage of the susceptor 1, there is a possibility of the lift member 3 failing to support the lower edge of the outer periphery of the wafer W. Therefore, it is necessary to employ a configuration in which, as shown in Figs. 8 and 9, a through hole 5 for passing the lift pin 4 therethrough is made relatively large while the lift pin 4 is connected to the distal end of a lift arm 6 which can be moved up and down. As a result, a gap is formed between the through hole 5 and the lift pin 4. This is considered to be a cause of the temperature distribution becoming uneven in the wafer support area 2.

Hence, it is an object of the present invention to provide a wafer supporting device having a lift mechanism capable of preventing damages in the underside of the wafer and positional deviations of the wafer from occurring, by which the temperature distribution in at least the support area for supporting the wafer can be made uniform.

### Disclosure of the Invention

In order to achieve the above-mentioned object, the present invention comprises a wafer support, disposed within a process chamber in a semiconductor manufacturing apparatus having respective heat sources in upper and lower regions thereof, having an upper surface provided with a support area for supporting a wafer; a plurality of lift members, each extending from the outside of the support area of the wafer support to the inside of the support area and having an upper surface provided with an inclined surface inclining downward toward the inside, movable up and down between respective positions above and below the upper surface of the wafer support; an arc-shaped lift ring, disposed outside the support area, having an inner peripheral edge integrally formed with the lift members; and a lift pin, adapted to move up and down through a through hole formed in the wafer support, having an upper end part connected to the lift ring; wherein the through hole is covered and substantially closed with the lift ring when the lift pin descends.

This eliminates the problem of the unevenness in temperature distribution caused by the gap between the through hole and the lift pin.

Since the lift pin is restricted by the lift ring, there is a fear of the lift pin strongly abutting against the inner wall surface of the through hole due to the difference in thermal expansion between the lift ring and the wafer support. Therefore, it will be effective if the through hole is formed as a long hole elongated in a diametrical direction of the wafer support.

In the state where the lift ring is raised by a claw member which is disposed at a position adjacent the lift member in the lift ring so as to be movable up and down, it will be effective if the claw member is adapted to be further raised while being separated from the lift ring. In such a configuration, the claw member positioned higher than the wafer can inhibit the wafer supported by the lift member from horizontally moving.

Preferably, the upper surface of the lift member has an upward convex cross-sectional form along a circumferential direction of the support area. As a consequence, the lift member and the wafer come into point contact with each other.

Those skilled in the art can see the above-mentioned object and other characteristic features and advantages by reading the following detailed descriptions with reference to the accompanying drawings.

### Brief Description of the Drawings

Fig. 1 is an explanatory view schematically showing an epitaxial growth apparatus in which the wafer supporting device of the present invention is employable;
Fig. 2 is a plan view of the wafer supporting device in accordance with a first embodiment of the present invention;
Fig. 3A is a sectional view taken along the line III-III of Fig. 2, showing a state where a wafer is supported on a susceptor;
Fig. 3B is a sectional view taken along the line III-III of Fig. 2, showing a state where the wafer is lifted from the susceptor;
Fig. 4 is a view seen in the direction of the line IV-IV of Fig. 3B;
Fig. 5 is a sectional view taken along the line V-V of Fig. 2;
Fig. 6 is an end face view taken along the line VI-VI of Fig. 2;
Fig. 7A is a view showing the wafer supporting device in accordance with a second embodiment of the present invention, showing a state where the wafer is supported on the susceptor;
Fig. 7B is a sectional view showing a state where the wafer is lifted from the susceptor;
Fig. 8 is a sectional view showing a configuration obtained in the process of conceiving the present invention; and
Fig. 9 is a plan view of a part of the configuration of Fig. 8.

### Best Modes for Carrying Out the Invention

In the following, preferred embodiments of the present invention will be explained in detail with reference to the drawings.

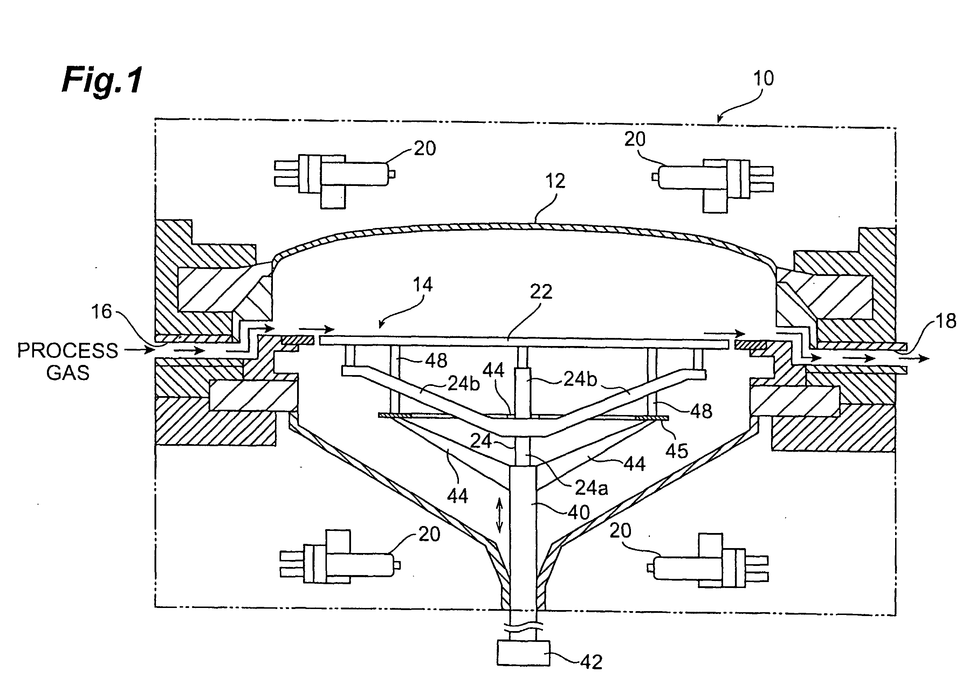

Fig. 1 schematically shows an epitaxial growth apparatus as a semiconductor manufacturing apparatus in which the wafer supporting device in accordance with the present invention can be installed. The shown epitaxial growth apparatus 10 is of a single wafer processing type in which silicon wafers (not shown in Fig. 1) are processed one by one, and comprises a process chamber 12 constituted by silica glass. A wafer supporting device 14 is disposed within the process chamber 12. A side portion of the process chamber 12 is formed with an inlet 16 for a process gas, whereas an outlet 18 is formed at a position opposite from the inlet 16. A plurality of halogen lamps 20 are radially disposed in each of upper and lower regions of the process chamber 12.

In thus configured epitaxial growth apparatus 10, after a wafer is supported by the wafer supporting device 14, the halogen lamps 20 are lit so as to heat the wafer, and trichlorosilane (SiHCl₃) gas, dichlorosilane (SiH₂Cl₂) gas, or the like is introduced as a process gas from the inlet 16 while air is discharged from the outlet 18, whereby the process gas flows in a laminar flow state along the surface of the wafer heated to a predetermined temperature, so that single crystals of silicon epitaxially grow on the wafer.

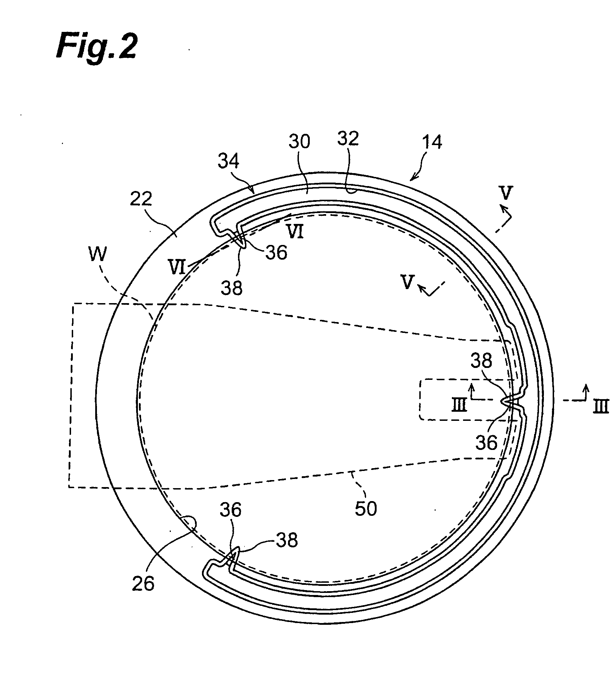

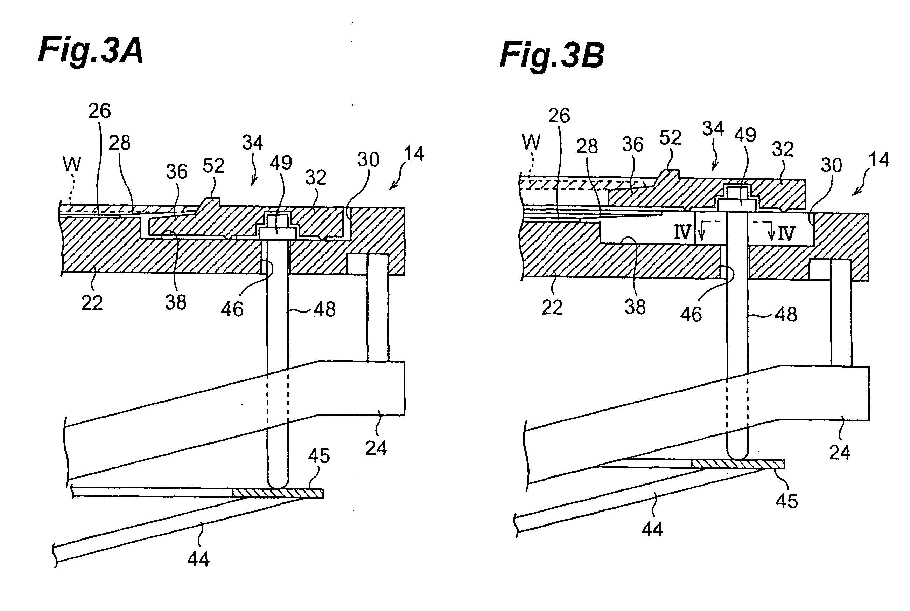

The wafer supporting device 14 in accordance with the first embodiment of the present invention in such an epitaxial apparatus 10 comprises a susceptor or wafer support 22 shown in Figs. 2 to 6. The susceptor 22 has a disk-like form and is made of a graphite material coated with silicon carbide. The susceptor 22 is horizontally supported at three points from the underside by a support shaft 24 made of silica glass vertically disposed in the lower part of the process chamber 12. The upper surface of the susceptor 22 is formed with a circular recess 26. The recess 26 acts as a support area for accommodating and supporting a wafer W. The outer peripheral portion of the bottom of the recess 26 is formed with an inclined surface 28 inclining downward toward the inside. Therefore, when the wafer W is disposed at a predetermined position within the recess 26 of the susceptor 22, the wafer W is supported while in a state where the lower edge (corner) of the outer periphery of the wafer W is in contact with the inclined surface 28 of the outer periphery of the recess 26 (see Fig. 3A). In this supporting state, the upper surface of the wafer W and the upper surface of the outer peripheral portion of susceptor on the outside of the recess 26 are substantially flush with each other. This configuration aims at causing the process gas introduced from the inlet 16 to flow while keeping its laminar flow state.

At the outer peripheral portion of the susceptor 22, a substantially arc-shaped (C-shaped) groove 30 is formed concentric with the susceptor 22. The angle of arc of the groove 30 is preferably about 250 degrees . Disposed within the groove 30 is an arc-shaped or C-shaped lift ring 32 having a form substantially identical to that of the groove 30.

In the state where the lift ring 32 is accommodated within the groove 30, the upper surface of the lift ring 32 and the upper surface of the outer peripheral portion of the susceptor 22 are flush with each other upon dimensioning, because of a reason similar to that mentioned above. Three lift members 36 are integrally provided at the inner peripheral edge of the lift ring 32 so as to project therefrom. Preferably, the three lift members 36 are disposed at intervals of about 120 degrees. Each lift member 36 extends toward the inside (toward the center of the susceptor 22), so that the free end thereof reaches an inside region of the recess 26. The portion of susceptor 22 corresponding to the lift member 36 is formed with a notch 38 having a form substantially identical to that of the lift member 36, so as not to hinder the lift ring 32 from being accommodated within the groove 30.

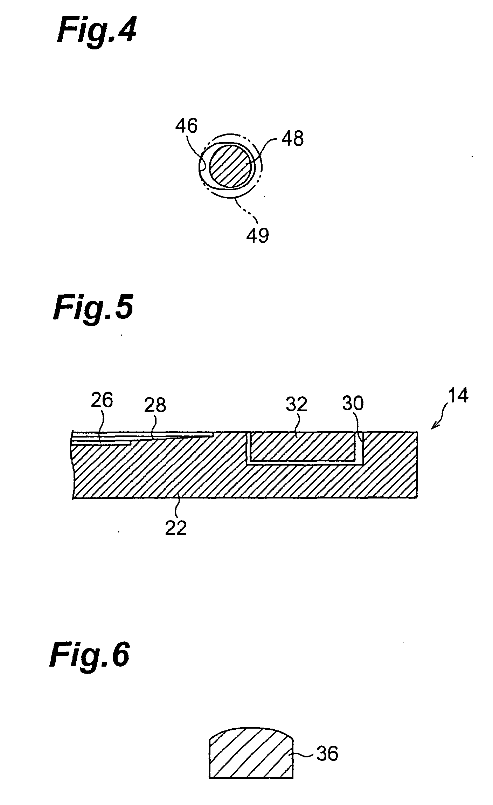

The upper surface of the lift member 36 is lower than the upper surface of the lift ring 32 by one step, and is positioned lower than the bottom surface of the recess 26, i.e., lower than at least the inclined surface 26 of the outer peripheral portion thereof, in the state where the lift ring 32 is accommodated within the groove 30. As a consequence, when the wafer W is supported on the susceptor 22, the wafer W does not come into contact with the lift member 36. Also, the upper surface of the lift member 36 is inclined downward toward the center of the susceptor 22. Further, as can be seen from Fig. 6, the upper surface of the lift member 36 is a curved surface which is upward convex in the circumferential direction of the susceptor 22.

As shown in Fig. 1, the lift mechanism 34 in accordance with this embodiment comprises a vertically movable lift tube 40 arranged so as to surround a main shaft 24a of the susceptor support shaft 24, a driving unit 42 for moving the lift tube 40 up and down, three lift arms 44 radially extending from the lift tube 40, and lift pins 48 suspended from the bottom surface of the groove 30 of the susceptor 22 by way of respective through holes 46 formed so as to penetrate therethrough. When the driving unit 42 is controlled so as to raise the lift tube 40 and lift arms 44 in such a configuration, the lift pins 48 are pushed up by the distal ends of the lift arms 44, whereby the lift ring 32 rises. The suspending of the lift pins 48 is carried out by flanges 49 formed at their upper ends.

As can be seen from Figs. 2, 3A, and 3B, the through holes 46 of the susceptor 22 are covered with the lift ring 32. The positions and dimensions of the through holes 46 and lift ring 32 are defined such that the through holes 46 are substantially closed when the lift pins 48 are moved down so that the lift ring 32 is accommodated in the groove 30.

At the time when the process is carried out, the susceptor 22 is horizontally rotated such that the process gas uniformly comes into contact with the wafer W. Therefore, the susceptor support shaft 24 supporting the susceptor 22 is driven to rotate. Since the lift pins 48 are passed through the through holes formed in the radially extending support arms 24b of the susceptor support shaft 24, they are rotated together with the susceptor support shaft 24 and susceptor 22. Therefore, it is preferred that a ring plate 45 for surrounding the main shaft 24a of the susceptor support shaft 24 be attached to the distal ends of the lift arms 44, so that the lift pins 48 can be pushed up no matter where the lift pins 48 are positioned in the rotating direction.

The upper ends of the lift pins 48 fit in a recess formed in the lower surface of the lift ring 32, whereby their movement is restrained by the lift ring 32.

Thus, the lift pins 48 are restrained by the lift arms 44 and the lift ring 32, whereas there is a difference in thermal expansion between the susceptor 22 and the lift arms and lift ring 32, whereby there will be a fear of the side surfaces of lift pins 48 strongly coming into contact with the inner wall surfaces of the through holes 46 during the epitaxial growth process if the inner diameter of the through holes 46 is on a par with the outer diameter of the lift pins 48. Therefore, in order to prevent such a state from occurring, the through holes 46 in this embodiment are formed as long holes extending in diametrical directions of the susceptor 22 as clearly shown in Fig. 4. While the longer axis of the through holes 46 can be determined as appropriate, it is preferably set such that, when the process is carried out, the through holes 46 are closed with the respective flanges 49 of the lift pins 48 so as to prevent the process gas from flowing through the through holes 46 from the upper side to the lower side.

When the wafer W is to be supported by thus configured wafer supporting device 14, a transfer robot is initially operated such that the wafer W mounted on a blade 50 of the robot is placed at a position directly above the recess 26 of the susceptor 22. Subsequently, the driving unit 42 for the lift mechanism 34 is controlled so as to raise the lift ring 32. At this time, since the blade 50 of the transfer robot is positioned at the open region of the lift ring 32 (see Fig. 2), it does not hinder the lift ring 32 from rising. When the lift ring 32 rises to a position higher than the blade 50, the wafer W is transferred from the blade 50 to the lift members 36 of the lift ring 32, so as to be supported by three points (see Fig. 3B). Since the upper surface of each lift member 36 is inclined downward toward the inside as mentioned above, the lift members 36 come into contact with only the lower edge of the outer periphery of the wafer W. The inclination of the lift member 36 also functions to suppress the horizontal movement of the wafer W. Since the upper surface of each lift member 36 is curved so as to become convex, it comes into contact with the wafer W by only one point. Though a difference in level formed between the lift members 36 and the lift ring 32 also prevents the wafer W from positionally shifting, it is preferred that a protrusion such as the one indicated by numeral 52 in Figs. 3A and 3B be provided since the wafer W may overrun the difference in level for some reason.

When the wafer W is supported by the lift members 36 of the lift ring 32, the blade 50 of the transfer robot is moved from above the susceptor 22 to the outside of the process chamber 12, and the lift ring 32 is moved down. Since the lift members 36 are positioned below the inclined surface 28 of the recess 26 of the susceptor 22 as shown in Fig. 3A when the lift ring 32 completely descends within the groove 32, the wafer W is supported by the inclined surface 28 of the recess 26. Thereafter, the above-mentioned epitaxial growth process is carried out.

Though a gap is formed between each through hole 46 and its corresponding lift pin 48, this gap is covered and closed with the lift ring 32 as mentioned above. In this embodiment, the gap is also closed with the flange 49 of the lift pin 48. Therefore, infrared rays from the halogen lamps 20 acting as the heat source disposed in the lower region of the process chamber 12 do not reach the upper surface side of the susceptor 22 through the gap, whereby this configuration contributes to homogenizing the temperature distribution of the recess (support area) 26. The homogenization of temperature distribution contributes to homogenizing the epitaxial growth within a plane.

It can easily be seen that, when the wafer W is to be lifted from the susceptor 22 and transferred to the blade 50 of the transfer robot, it will be sufficient if the lift mechanism and the transfer robot are operated in a sequence which is the reverse of that mentioned above.

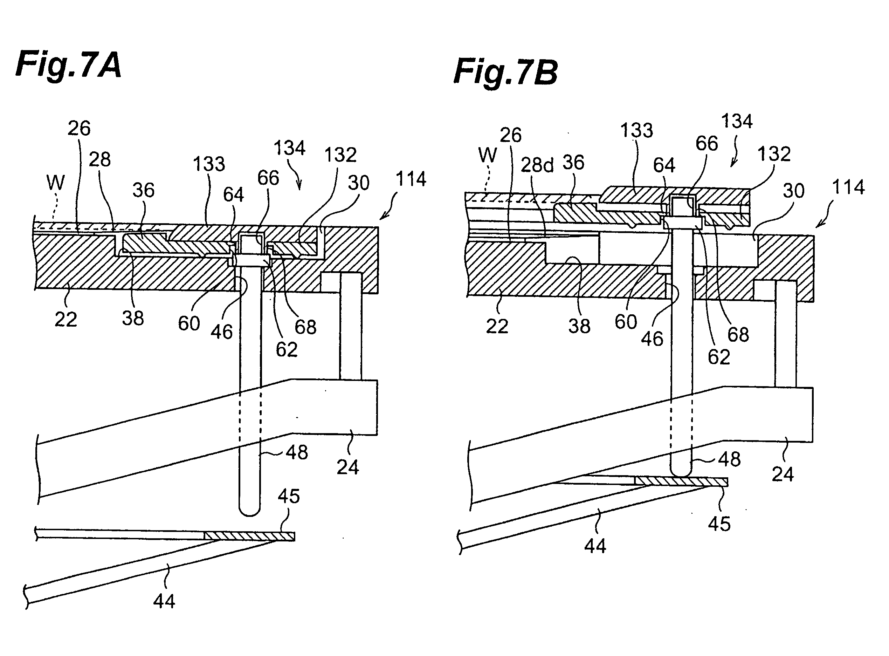

Figs. 7A and 7B show a wafer supporting device 114 in accordance with a second embodiment of the present invention. In the second embodiment, parts identical or equivalent to those in the first embodiment are referred to with numerals identical thereto without repeating their detailed explanations. A lift mechanism 134 in the wafer supporting device 114 in the second embodiment comprises three claw members 133 on a C-shaped lift ring 132. The part of lift ring 132 where the claw members 133 are positioned is formed with a recess where the claw members 133 are placed. In the state where the claw members 133 fit in the recess (see Fig. 7A), the lift ring 132 has a form substantially identical to the lift ring 32 of the first embodiment. The claw members 133 are arranged at positions adjacent the lift members 36. Therefore, the number of claw members 133 is identical to that of the lift members 36, i.e., 3.

At a position where the upper end of each lift pin 48 comes into contact, the lift ring 132 is formed with a through hole 60. Though the through hole 60 receives a collar 62 formed at the upper end portion of the lift pin 48, the upper end portion of hole 60 is formed with an inward flange 64 so that it can be lifted by the lift pin 48.

On the other hand, each claw member 133 is formed with a counter bore 66 at a position corresponding to that mentioned above. The inner diameter of the counter bore 66 is substantially the same as the outer diameter of the upper end of the lift pin 48. Further, a portion of the lower surface surrounding the counter bore 66 is formed with a cylindrical protrusion 68. When the claw members 133 are superposed on the lift ring 132, the cylindrical protrusions 68 fit into their corresponding through holes 60 of the lift ring 132.

In such a configuration, in the state where the lift pins 48 are lowered, the claw members 133 are superposed on the lift ring 132 as shown in Fig. 7A, whereby a state substantially the same as that of Fig. 3A is attained. Namely, the through holes 46 are covered and closed with the lift ring 132.

When the lift pins 48 are raised, the cylindrical protrusions 68 of the claw members 133 are initially pushed up by the brims 62 of the lift pins 48. As a consequence, only the claw members 133 rise, so as to be separated from the lift ring 132. In this state, the difference in level between the upper surface of the lift members 36 and the upper surface of the claw members 133 becomes greater, which enhances the effect of preventing the wafer W from moving horizontally. Hence, it becomes unnecessary to provide the protrusion 52 shown in Figs. 3A and 3B. When the lift pins are further raised, the collar 62 of each lift pin 48 comes into contact with the lower surface of the flange 64 of its corresponding through hole 60, whereby the claw members 133 and the lift ring 132 rise together. Other effects are similar to those of the first embodiment.

Though preferred embodiments of the present invention are explained in the foregoing, the present invention is not limited thereto as a matter of course. For example, though the semiconductor manufacturing apparatus in the above-mentioned embodiments are epitaxial growth apparatus, the present invention is also applicable to those carrying out other kinds of heat treatment, e.g., thermal CVD apparatus.

### Industrial Applicability

In accordance with the present invention as explained in the foregoing, when a wafer is supported by a wafer support such as a susceptor or, on the contrary, raised from the wafer support, the wafer is moved up and down in a state supported by the lower edge of its outer periphery alone, whereby the underside of the wafer is not damaged. Though there is a possibility of the lower edge of the outer periphery of the wafer being damaged even in the wafer supporting device of the present invention, damages in this part do not become problematic in particular.

Also, since the through holes for passing lift pins therethrough are closed by the lift ring, the through holes can be restrained from adversely affecting the temperature distribution of the wafer support area, whereby favorable results of the process can be obtained, which contributes to improving the yield and performances of semiconductor devices.

## Claims

1. A wafer supporting device comprising:
a wafer support, disposed within a process chamber in a semiconductor manufacturing apparatus having respective heat sources in upper and lower regions thereof, having an upper surface provided with a support area for supporting a wafer;
a plurality of lift members, extending from the outside of said support area of said wafer support to the inside of said support area and having an upper surface provided with an inclined surface inclining downward toward the inside, movable vertically between respective positions above and below said upper surface of said wafer support;
an arc-shaped lift ring, disposedoutside said support area, having an inner peripheral edge integrally formed with said lift members; and
a lift pin, adapted to verticallymove througha through hole formed in said wafer support, having an upper end connected to said lift ring;
wherein said through hole is covered and substantially closed with said lift ring when said lift pin descends.

2. A wafer supporting device according to claim 1, further comprising driving means, disposed lower than said lift pin, for vertically moving said lift pin.

3. A wafer supporting device according to claim 2, wherein said lift pin and said driving means are separable from each other.

4. A wafer supporting device according to claim 1, wherein said through hole is a long hole elongated in a diametrical direction of said wafer support.

5. A wafer supporting device according to claim 1, wherein said lift ring has a claw member which is disposed at a position adjacent said lift member so as to be movable vertically, said claw member being adapted to be further raised while being separated from said lift ring in a state where said lift ring is raised.

6. A wafer supporting device according to claim 1, wherein the upper surface of said lift member has an upward convex cross-sectional form along a circumferential direction of said support area.

7. A wafer supporting device according to claim 1, wherein said wafer support is rotatable.

8. A wafer supporting device according to claim 7, wherein said semiconductor manufacturing apparatus is an epitaxial growth apparatus.
